(19) Europäisches Patentamt / European Patent Office / Office européen des brevets

(11) **EP 4 760 305 A1**

(12) **EUROPEAN PATENT APPLICATION**

(43) Date of publication:
**17.06.2026 Bulletin 2026/25**

(21) Application number: **25220988.7**

(22) Date of filing: **05.12.2025**

(51) International Patent Classification (IPC):
**G01R 31/389** *(2019.01)* **G01R 31/392** *(2019.01)*

(52) Cooperative Patent Classification (CPC):
**G01R 31/389;** G01R 31/392

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **16.12.2024 US 202418982275**

(71) Applicant: **General Electric Company**
**Cincinnati, Ohio 45215 (US)**

(72) Inventors:
• **PANG, Tiancan**
  **Niskayuna, 12309 (US)**
• **LI, Cong**
  **Nikayuna, 12309 (US)**
• **MUELLER, Frank Jakob John**
  **Niskayuna, 12309 (US)**
• **ACHARYA, Sayan**
  **Niskayuna, 12309 (US)**

(74) Representative: **Openshaw & Co.**
**8 Castle Street**
**Farnham, Surrey GU9 7HR (GB)**

(54) **METHOD AND SYSTEM FOR A BATTERY MONITORING CIRCUIT**

(57) An assembly for measuring impedance of a battery (24) includes a first current loop (102, 202) including a first capacitor (110, 206) and a second capacitor (112, 208) in series with the first capacitor, a second current loop (104, 204) in parallel with the first current loop, the second current loop including a third capacitor (120, 210), an impedance sensor (106) in electrical communication with the first and second current loops, and a controller module (108) configured to determine an impedance of the battery based on data from the impedance sensor indicating a first current frequency (f1) from the first current loop and a second current frequency (f2) from the second current loop.

FIG. 3A

EP 4 760 305 A1

**Description**

FEDERALLY SPONSORED RESEARCH

This invention was made with government support under contract number 80AFRC-21-C-A021 awarded by the National Aeronautics and Space Administration. The U.S. government may have certain rights in the invention.

FIELD

The present disclosure relates to a battery monitoring circuit used for determining the health of one or more batteries.

BACKGROUND

A battery is used as an energy source to feed DC electrical loads. During the lifetime of a battery, its health may deteriorate, which can result in a decreased power output of the battery or of its capacity. One method of determining the health of a battery is by measuring and evaluating its impedance. Impedance measurement is done by injecting a sinusoidal current into the battery terminals and measuring the injected sinusoidal current and the voltage across the battery. The battery impedance is then estimated through use of the sinusoidal current and the measured battery voltage.

BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:

FIG. 1 is a top-down schematic view of an aircraft and its power distribution system.
FIGS. 2A-2B are schematic diagrams of an assembly for measuring an impedance of a battery.
FIGS. 3A-3B are schematic diagrams of the assembly of FIGS. 2A-2B with a battery connected to a first current loop.
FIGS. 4A-4B are schematic diagrams of the assembly of FIGS. 2A-2B with the battery connected to a second current loop.
FIG. 5 is a schematic diagram of another assembly for measuring an impedance of a battery.
FIGS. 6A-6B are schematic diagrams of the assembly of FIG. 5 with a battery connected to a first current loop.
FIGS. 7A-7B are schematic diagrams of the assembly of FIG. 5 with the battery connected to a second current loop.
FIG. 8 is a schematic view of an exemplary controller.
FIG. 9 is a block diagram of an exemplary method for determining an impedance of a battery.

DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise.

The term "at least one of" in the context of, e.g., "at least one of A, B, and C" refers to only A, only B, only C, or any combination of A, B, and C.

The phrases "from X to Y" and "between X and Y" each refers to a range of values inclusive of the endpoints (i.e., refers to a range of values that includes both X and Y).

As used herein, the terms "first," "second," "third," and other ordinals are used to distinguish one component from another and are not intended to signify location or importance of the individual components.

As used herein, while sensors can be described as "sensing" or "measuring" a respective value, sensing or measuring can include determining a value indicative of or related to the respective value, rather than directly sensing or measuring the value itself. The sensed or measured values can further be provided to additional components. For instance, the value can be provided to a controller module or processor, and the controller module or processor can perform processing on the value to determine a representative value or an electrical characteristic representative of said value. Additionally, while terms such as "voltage", "current", and "power" can be used herein, it will be evident to one skilled in the art that these terms can be interrelated when describing aspects of the electrical circuit, or circuit operations.

Connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other. In non-limiting examples, connections or disconnections can be selectively configured, connected, or connectable to provide, enable, disable, or the like, an electrical connection between respective elements. Non-limiting example power distribution bus connections or disconnections can be enabled or operated by way of switching, bus tie logic, or any other connectors configured to enable or disable the energizing of electrical loads downstream of the bus, or between buses.

Directional references such as upstream and downstream are used with respect to a circuit. As used herein, the terms directional references in terms of the circuit are with respect to the flow of current within the circuit.

As used herein, a "controller" or "controller module" can include at least one processor and memory. Non-limiting examples of the memory can include Random Access Memory (RAM), Read-Only Memory (ROM), flash memory, or one or more different types of portable electronic memory, such as discs, DVDs, CD-ROMs, etc., or any suitable combination of these types of memory. The processor can be configured to run any suitable programs or executable instructions designed to carry out various methods, functionality, processing tasks, calculations, or the like, to enable or achieve the technical operations or operations described herein. The program can include a computer program product that can include machine-readable media for carrying or having machine-executable instructions or data structures stored thereon. Such machine-readable media can be any available media, which can be accessed by a general purpose or special purpose computer or other machine with a processor. Generally, such a computer program can include routines, programs, objects, components, data structures, algorithms, etc., that have the technical effect of performing particular tasks or implement particular abstract data types.

As used herein, a controllable switching element, or a "switch" is an electrical device that can be controllable to toggle between a first mode of operation, wherein the switch is "closed" intending to transmit current from a switch input to a switch output, and a second mode of operation, wherein the switch is "open" intending to prevent current from transmitting between the switch input and switch output. In non-limiting examples, connections or disconnections, such as connections enabled or disabled by the controllable switching element, can be selectively configured to provide, enable, disable, or the like, an electrical connection between respective elements.

An "impedance" of a component is an opposition to alternating current presented by a combined effect of resistance and reactance.

The present disclosure is generally related to a system for determining a health status of a battery or battery stack. Typical systems are rated for lower voltages than those output by the battery, so the instruments to measure the health of the battery may not be able to be used directly. Battery health is important for hybrid-electric vehicles to determine whether to perform maintenance or replace the batteries.

By using passive capacitive networks to balance voltages between the battery and measurement instruments, the health of the battery can be measured. Specifically, the impedance of the battery can be determined based on data measured by the measurement instruments, such as impedance sensors, at voltages to which the measurement instruments are rated. By forming symmetric structures, the phase-to-neutral and phase-to-ground voltages are balanced.

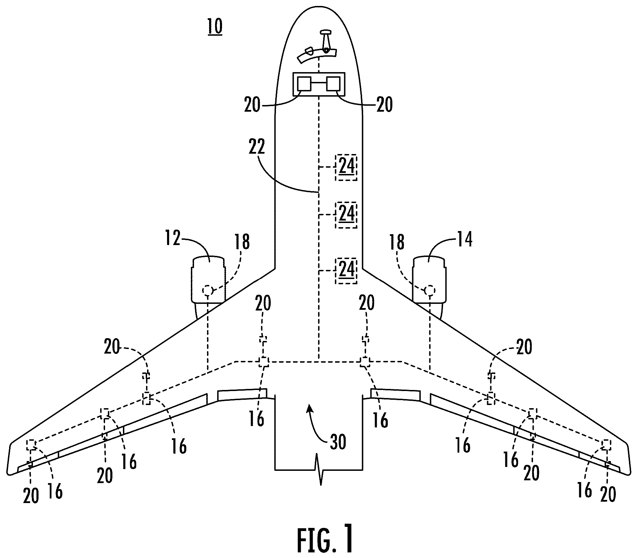

Referring now to the drawings, wherein identical numerals indicate the same elements throughout the figures, FIG. 1 is a schematic illustration of an aircraft 10. The aircraft 10 has a power system. The power system can, for example, include at least one turbine engine, shown as a left engine system 12 and a right engine system 14. The left and right engine systems 12, 14 can be substantially identical, and can further include at least one power source, illustrated respectively as one or more generators 18. At least one of the generators 18 can include variable speed or variable output generators. In this example, a variable speed or variable output generator can include a generator adapted or configured to operate within a predetermined range of input speed, gearbox speed ratios, or the like, and can generate a power output within a predetermined output range (e.g. voltage output range, current output range, frequency output range, or a combination thereof). In one non-limiting example, a variable output generator can include a generator adapted or configured to output approximately 115 Volts AC between 390 Hz and 410 Hz.

The aircraft 10 is shown further having one or more power-consuming components, or electrical loads 20, such as for instance, an actuator load, flight critical loads, and non-flight critical loads. The electrical loads 20 are electrically coupled with at least one of the generators 18 via a power distribution system 30 including, for instance, one or more transmission lines 22, bus bars, power buses (or the like), and one or more power distribution nodes 16.

The aircraft 10 can further include one or more batteries 24 selectively connectable with the one or more transmission lines 22, and operable to provide at least a portion of primary power, supplemental power, redundant power, backup power, emergency power, or the like to at least a portion of the aircraft 10. As shown, the batteries 24 can provide power to the one or more transmission lines 22, and thus, the one or more power distribution nodes 16 or the one or more electrical loads 20.

In the aircraft 10, the operating left and right engine systems 12, 14 provide mechanical energy which can be extracted, typically via a spool, to provide a driving force for the one or more generators 18. The one or more generators 18, in turn, generate power, such as AC or DC power, and provides the generated power to the transmission lines 22, which delivers the power to the electrical loads 20, positioned throughout the aircraft 10. Furthermore, during operation, the one or more batteries 24 can be selectively connected with the transmission lines 22, and operable to provide primary or supplemental power to fewer than all of the one or more of the electrical loads 20, i.e., a subset of the electrical loads 20.

Example power distribution management functions can include, but are not limited to, selectively enabling or disabling the delivery of power to particular electrical loads 20, depending on, for example, available power distribution supply, criticality of electrical load functionality, or aircraft mode of operation, such as takeoff, cruise, or ground operations. During emergency or inadequate periods of electrical power generation, including but not limited to engine or generator failure, at least one of one or more batteries 24 operable to provide supplemental power can be operated, enabled, or connected for providing power to the electrical loads 20. Additional management functions can be included.

It will be understood that while aspects of the disclosure are shown in an aircraft environment of FIG. 1, the disclosure is not so limited and can have applicability in a variety of environments. For example, while this description is directed toward a power system architecture in an aircraft, aspects of the disclosure can be further applicable to provide power, supplemental power, emergency power, essential power, or the like, in otherwise non-emergency operations, such as takeoff, landing, or cruise flight operations.

Furthermore, the number of, and placement of, the various components depicted in FIG. 1 are also non-limiting examples of aspects associated with the disclosure. For example, while various components have been illustrated with relative position of the aircraft 10 (e.g. the one or more electrical loads 20 on the wings of the aircraft 10, etc.), aspects of the disclosure are not so limited, and the components are not so limited based on their schematic depictions.

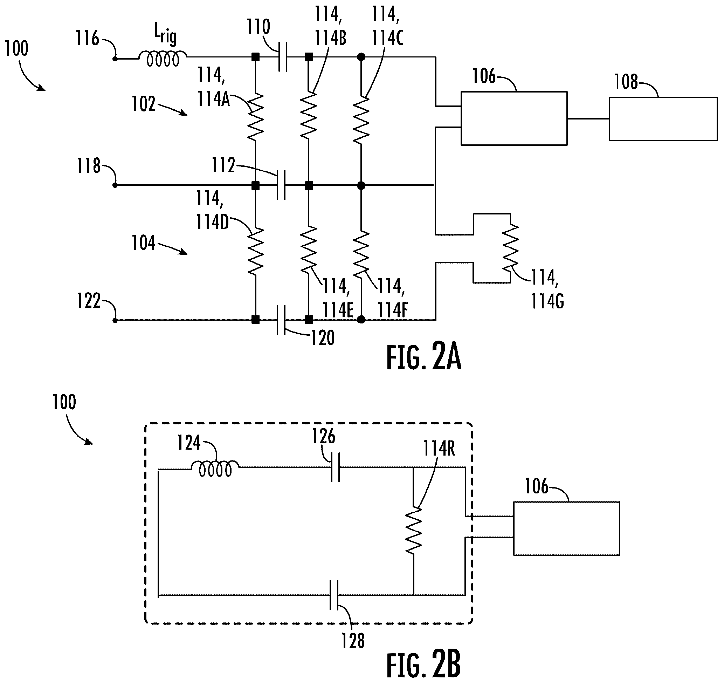

With reference to FIGS. 2A-2B, a schematic view of an assembly 100 for measuring an impedance of one of the one or more batteries 24 of an aircraft 10 is shown. FIG. 2A shows a schematic view of specific components of the assembly 100. FIG. 2B shows a schematic view of an equivalent circuit of the assembly 100.

Now referring to FIG. 2A, the assembly 100 includes a first current loop 102, a second current loop 104, an impedance sensor 106, and a controller module 108. The impedance sensor 106 collects data from the first and second current loops 102, 104, and the controller module determines an impedance of a battery 24 (which may be one of the one or more batteries 24) connected to one of the first or second current loops 102, 104. The impedance sensor 106 is in electrical communication with the first and second current loops 102, 104. The controller module 108 collects data from the impedance sensor 106 to determine the impedance. The assembly 100 may be used to determine the impedance of the one or more batteries 24 while the one or more batteries 24 are still installed on the aircraft 10. Alternatively, the one or more batteries 24 may be removed from the aircraft 10 prior to testing with the assembly 100.

The first current loop 102 includes a first capacitor 110, a second capacitor 112, and at least one resistor 114. The first current loop 102 extends from a first terminal 116 to a second terminal 118. When the first terminal 116 is connected to the second terminal 118, the first current loop 102 is closed. When the first and second terminals 116, 118 are connected to each other without the battery 24, the controller module 108 can determine properties of the first current loop 102.

In the example of FIG. 2A, the first current loop 102 includes three resistors 114A, 114B, 114C (collectively, "resistors 114"). Each of the resistors 114 has a resistance, and the resistance of each resistor 114 may be a same resistance or a different resistance from each of the other resistors 114. Each of the resistors 114 is in parallel to each of the other resistors 114. It will be appreciated that any single resistor 114 may represent two or more resistors 114 arranged in series.

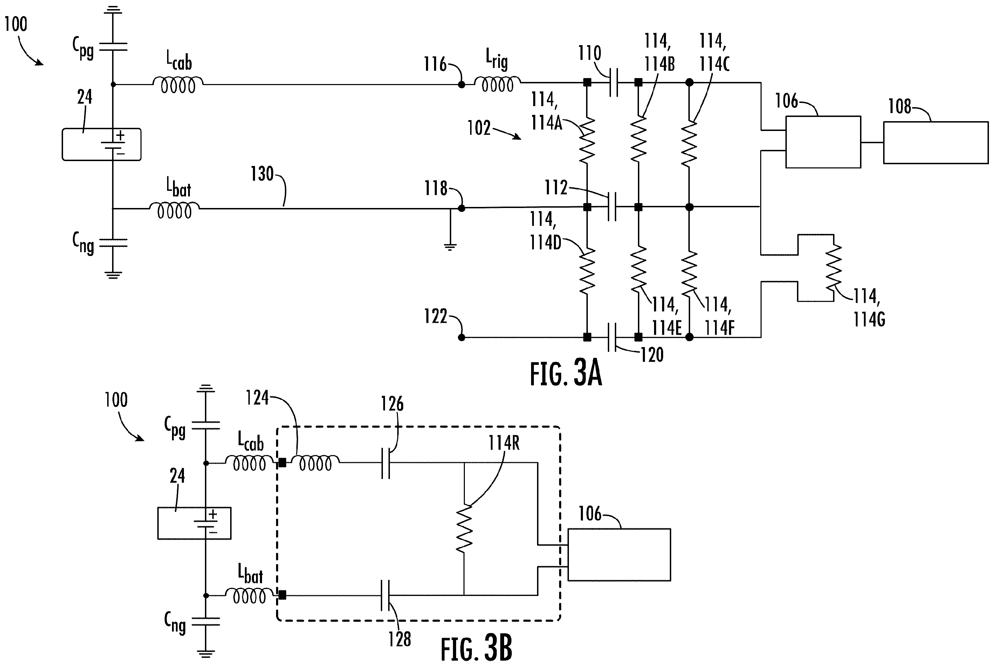

The first and second capacitors 110, 112 are arranged in series. The first and second capacitors 110, 112 block steady state high voltage of the battery 24 (FIGS. 3A-4B) from a low voltage of the impedance sensor 106, reducing stress on the battery 24 (FIGS. 3A-4B) and the impedance sensor 106. Specifically, the impedance sensor 106 is shielded from the battery 24 by the first and second capacitors 110, 112. The first capacitor 110 has a first capacitance $C_1$, and the second capacitor 112 has a second capacitance $C_2$. The first and second capacitances $C_1$, $C_2$ can be specified to provide the voltage balance between the battery 24 and the impedance sensor 106. In particular, the first and second capacitors 110, 112 balance a phase-to-ground (P-G) voltage and a neutral-to-ground (N-G) voltage.

The second current loop 104 includes the first capacitor 110, a third capacitor 120, and at least one resistor 114. The second current loop 104 extends from the first terminal 116 to a third terminal 122, and the second terminal 118 is connected to a ground. When the first terminal 116 is connected to the third terminal 120, the controller module 108 can determine properties of the second current loop 104.

The assembly 100 includes a plurality of additional resistors 114D, 114E, 114F, 114G that, when the first terminal 116 is connected to the third terminal 120, are in series with the resistors 114A, 114B, 114C. The third capacitor 120 has a third capacitance $C_3$.

Now referring to FIG. 2B, a schematic diagram of the equivalent circuit of the assembly 100 is shown. In the equivalent circuit, the resistors are represented as a single, representative resistor 114R and an inductor 124 is shown to represent the inherent inductance of the components of the assembly. The first, second, and third capacitors 110, 112, 120 are shown as a first representative capacitor 126 and a second representative capacitor 128. The first representative capacitor 126 has a first representative capacitance $C_{R1}$, and the second representative capacitor 128 has a second representative capacitance $C_{R2}$. In the assembly of FIGS. 2A-2B, the first capacitor 110 is the first representative capacitor 126, and the first representative capacitance $C_{R1}$ is the same as the first capacitance $C_1$. In the first current loop 102, the second capacitor 112 is the second representative capacitor 128, and the second representative capacitance $C_{R2}$ is the second capacitance $C_2$. In the second current loop 104, the third capacitor 120 is the second representative capacitor 128, and the second representative capacitance $C_{R2}$ is the third capacitance $C_3$.

The equivalent circuit allows the controller module 108 to determine values of properties of the assembly 100. In particular, the inductance $L_{rig}$ of the assembly 100 can be determined according to Expression 1:

$$L_{rig} = \frac{1}{(2\pi \cdot f_{r,rig})^2 \cdot \dfrac{C_{R1}C_{R2}}{C_{R1} + C_{R2}}} \qquad (1)$$

where $f_{r,rig}$ is a measured resonant frequency of alternating current in the first current loop 102 or the second current loop 104, as measured by the impedance sensor 106. The inductance $L_{rig}$ is one of the parameters that the controller module 108 determines in order to determine the impedance of the battery 24 (FIGS. 3A-4B).

Now referring to FIGS. 3A-3B, the assembly 100 is shown with a battery 24. FIG. 3A is a schematic view of the assembly 100. FIG. 3B is a schematic view of an equivalent circuit of the assembly 100.

As shown in FIG. 3A, the battery is connected to the first current loop 102. More specifically, one or more cables 130 connect terminals of the battery 24 to the first and second terminals 116, 118. The battery 24 has a battery inductance $L_{bat}$, and the one or more cables 130 have a combined cable inductance $L_{cab}$, represented by inductors in FIG. 3A. The battery 24 has a phase-to-ground capacitance $C_{pg}$ and a neutral-to-ground capacitance $C_{ng}$, represented by capacitors in FIG. 3A. The sum of the phase-to-ground capacitance $C_{pg}$ and the neutral-to-ground capacitance $C_{ng}$ is a common mode (CM) impedance $C_{bat}$ of the battery 24.

Referring now to FIG. 3B, the equivalent circuit illustrates parameters of the assembly 100. The controller module 108 is configured to determine a differential mode (DM) impedance when the battery 24 is connected to the first and second terminals 116, 118. Specifically, the DM impedance is the sum of the battery inductance $L_{bat}$ and the cable inductance $L_{cab}$, and the controller module 108 determines the DM impedance with data from the impedance sensor 106 according to Expression 2:

$$L_{cab} + L_{bat} = \frac{1}{\left(2\pi \cdot f_{r,DM}\right)^2 \cdot \dfrac{C_{R1}C_{R2}}{C_{R1} + C_{R2}}} - L_{rig} \qquad (2)$$

where $f_{r,DM}$ is a measured resonant frequency of alternating current in the first current loop 102 when the battery 24 is connected, as measured by the impedance sensor 106.

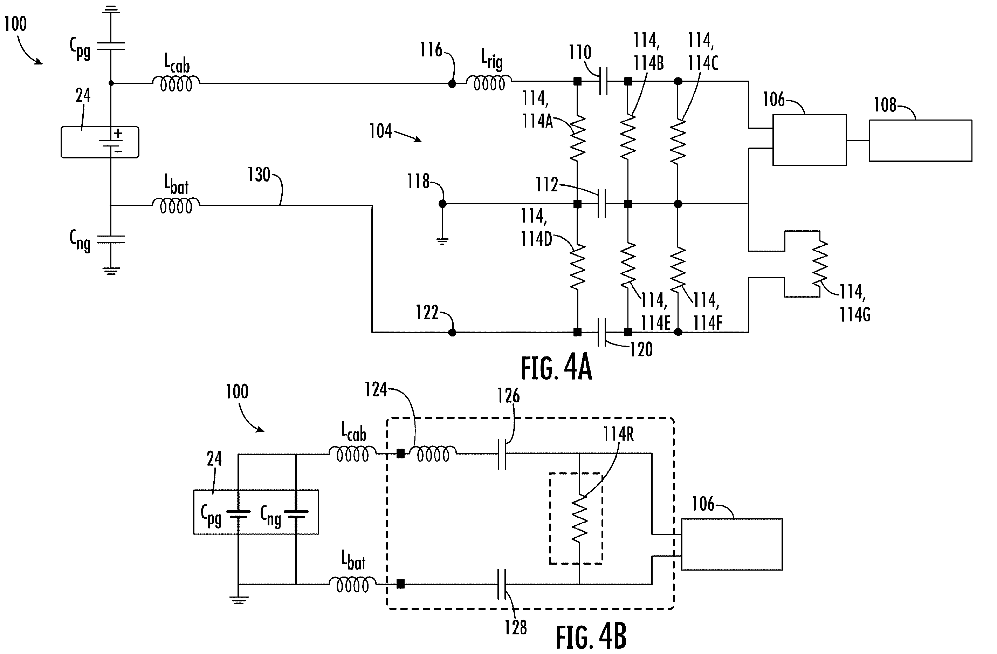

Now referring to FIGS. 4A-4B, the assembly is shown with the battery 24 connected to the second current loop 104. Fig. 4A is a schematic view of the assembly 100. FIG. 4B is a schematic view of an equivalent circuit of the assembly 100.

As shown in FIG. 4A, the battery 24 is connected to the second current loop 104. More specifically, the battery 24 is connected to the first and third terminals 116, 122, and the second terminal 118 is connected to ground. Thus, current bypasses the second capacitor 112, and the first and third capacitors 110, 120 provide the voltage balance with the battery 24.

With reference to FIG. 4B, the controller module 108 can determine the CM impedance $C_{bat}$ of the battery 24 with data from the impedance sensor 106 according to Expression 3:

$$C_{bat} = \frac{1}{\left(2\pi \cdot f_{r,CM}\right)^2 \left(L_{rig} + \dfrac{L_{cab} + L_{bat}}{2}\right) - \dfrac{C_{R1}+C_{R2}}{C_{R1}C_{R2}}} \qquad (3)$$

where $f_{r,CM}$ is a measured resonant frequency of alternating current in the second current loop 104 when the battery 24 is connected, as measured by the impedance sensor 106. In this manner, the controller module 108 determines the impedance of the battery 24 with the assembly 100. The determined impedance may be output to a memory of the controller module 108 for use in determining whether to replace or repair the battery 24.

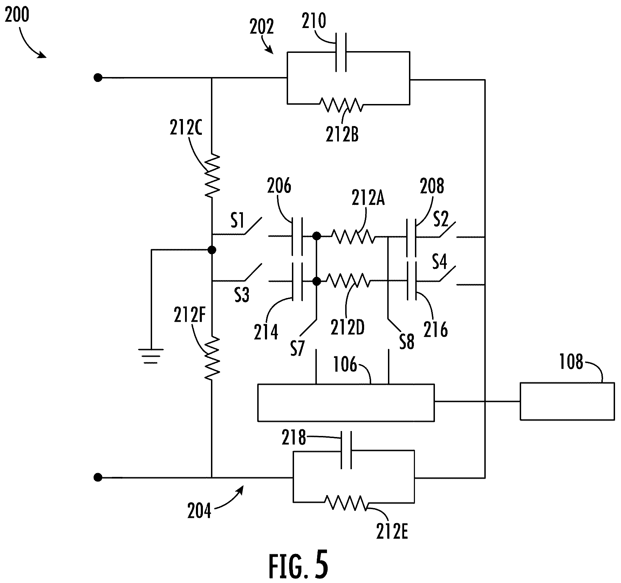

Now referring to FIG. 5, a schematic view of another assembly 200 for measuring the impedance of one of the one or more batteries 24 is shown. The assembly 200 includes a first current loop 202, a second current loop 204, an impedance sensor 106, and a controller module 108. The impedance sensor 106 collects data from the first and second current loops 202, 204, and the controller module 108 determines an impedance of a battery (which may be one of the one or more batteries 24) connected to one of the first or second current loops 202, 204. The controller module 108 collects data from the impedance sensor 106 to determine the impedance.

The first current loop 202 includes a first capacitor 206, a second capacitor 208, a third capacitor 210, a first switch S1, a second switch S2, a first resistor 212A, a second resistor 212B, and a third resistor 212C (collectively, "resistors 212"). As with the assembly 100 of FIGS. 2A-4B, the first capacitor 206 has a first capacitance $C_1$, the second capacitor 208 has a second capacitance $C_2$, and the third capacitor 210 has a third capacitance $C_3$.

The second current loop 204 includes a fourth capacitor 214, a fifth capacitor 216, a sixth capacitor 218, a third switch S3, a fourth switch S4, a fourth resistor 212D, a fifth resistor 212E, and a sixth resistor 212F. The fourth capacitor has a fourth capacitance $C_4$, the fifth capacitor has a fifth capacitance $C_5$, and the sixth capacitor has a sixth capacitance $C_6$. As with the assembly 100 of FIGS. 2A-4B, the capacitors 210, 218 provide voltage balance between the battery and the impedance sensor 106.

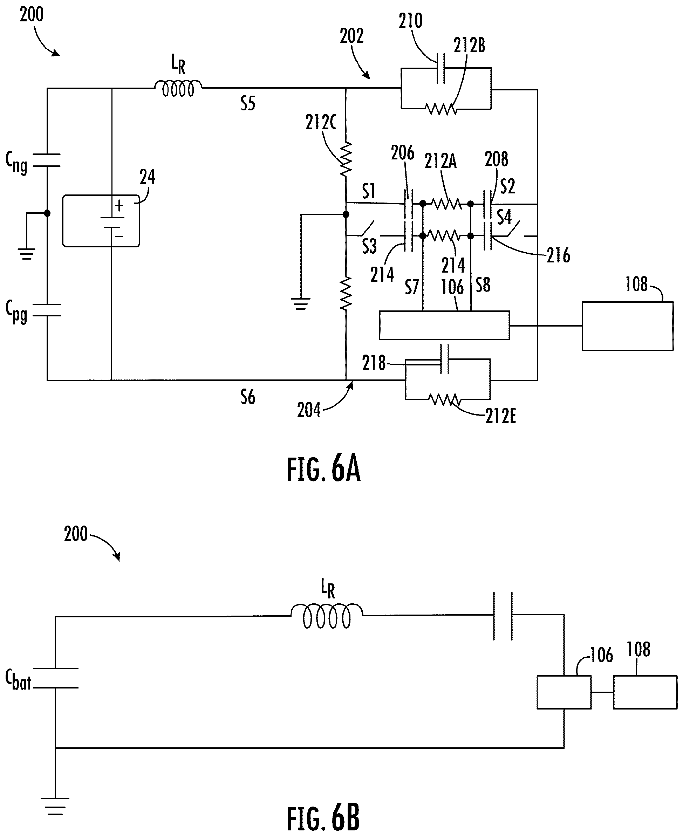

The assembly 200 includes a fifth switch S5 and a sixth switch S6 that connect the impedance sensor 106 to the first and second current loops 202, 204. The assembly 200 further includes a seventh switch S7 and an eighth switch S8 that connect the first and second current loops 202, 204 to a battery 24 (FIGS. 6A-7B). The controller module 108 actuates selective ones of the switches S1-S8 to form the first and second current loops 202, 204.

With reference to FIGS. 6A-6B, the assembly 200 is shown with a battery 24 connected to the first current loop 202. FIG. 6A is a schematic view of the assembly 200. FIG. 6B is a schematic view of an equivalent circuit of the assembly 200 of FIG. 6A.

Referring now to FIG. 6A, the battery 24 is connected to the first current loop 202. Specifically, the third and fourth switches S3, S4 are open, and the other six switches S1-S2, S5-S8 are closed, connecting the battery 24 to the impedance sensor 106 with the first current loop 202. The first, second, and third capacitors 206, 208, 210 provide voltage balance between the battery 24 and the impedance sensor 106.

Referring now to FIG. 6B, the equivalent circuit illustrates parameters of the assembly 200. Specifically, the first, second, and third capacitances $C_1$, $C_2$, $C_3$ are combined into a first representative capacitance $C_{R1}$, the CM impedance of the battery 24 is $C_{bat}$, and the inductances $L_{bat}$, $L_{cab}$, $L_{rig}$ can be represented as a representative inductance $L_R$. The controller module 108 determines a first constant $k_1$ according to Expression 4:

$$\frac{C_{bat}C_{R1}L_R}{C_{bat}+C_{R1}} = \frac{1}{4\pi^2 f_1^2} = k_1 \qquad (4)$$

where $f_1$ is a measured resonant frequency of alternating current in the first current loop 202 when the battery 24 is connected, as measured by the impedance sensor 106.

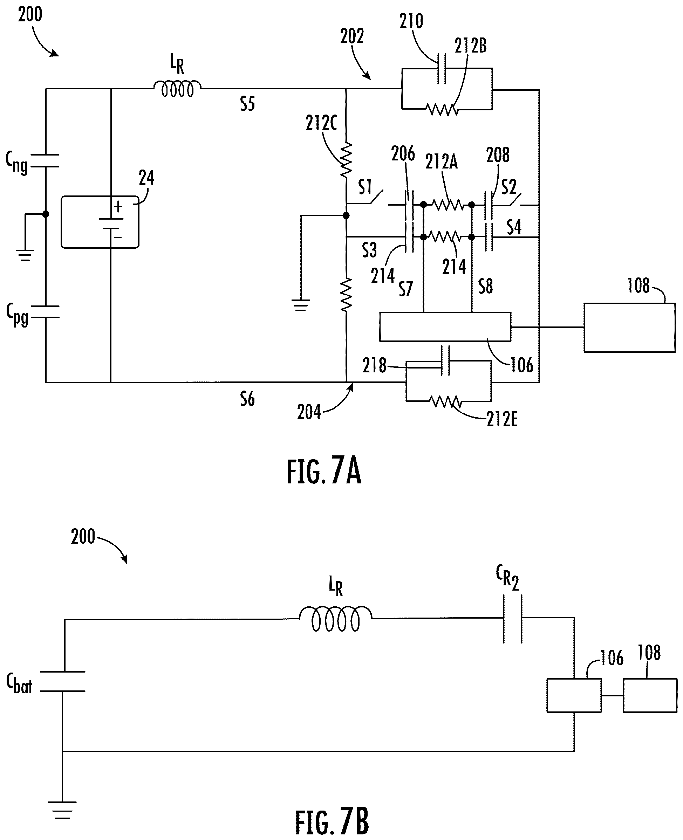

With reference to FIGS. 7A-7B, the assembly 200 is shown with the battery 24 connected to the second current loop 204. FIG. 7A is a schematic view of the assembly 200. FIG. 7B is a schematic view of an equivalent circuit of the assembly 200 of FIG. 7A.

Referring now to FIG. 7A, the battery 24 is connected to the second current loop 204. Specifically, the first and second switches S1, S2 are open, and the other six switches S3-S8 are closed, connecting the battery 24 to the impedance sensor 106 with the second current loop 204. The fourth, fifth, and sixth capacitors provide voltage balance between the battery 24 and the impedance sensor 106. The controller module 108 can actuate the switches to disconnect the battery 24 from the first current loop 202 and to connect the battery 24 to the second current loop 204.

Referring now to FIG. 7B, the equivalent circuit illustrates parameters of the assembly 200. Specifically, the fourth, fifth, and sixth capacitances $C_4$, $C_5$, $C_6$ are combined into a second representative capacitance $C_{R2}$, and the controller module 108 determines a second constant $k_2$ according to Expression 5:

$$\frac{C_{bat}C_{R2}L_R}{C_{bat}+C_{R2}} = \frac{1}{4\pi^2 f_2^2} = k_2 \qquad (5)$$

where $f_2$ is a measured resonant frequency of alternating current in the second current loop 204 when the battery 24 is connected, as measured by the impedance sensor 106.

Based on the first and second constants $k_1$, $k_2$, the controller module 108 can determine the CM impedance $C_{bat}$ and the representative inductance $L_R$ according to Expressions 6 and 7:

$$C_{bat} = \frac{(k_1 - k_2) \cdot C_{R1} C_{R2}}{k_2 C_{R1} - k_1 C_{R2}} \qquad (6)$$

$$L_R = \frac{k_1 (C_{bat} + C_{R1})}{C_{bat} C_{R1}} \qquad (7)$$

The controller module 108 is configured to actuate the switches to connect the battery 24 to the first and second loops 202, 204 to determine the CM impedance $C_{bat}$. The controller module 108 actuates the first, second, fifth, and sixth switches S1, S2, S5, S6 to connect the battery 24 to the first, second, and third capacitors 206, 208, 210. Then, the controller module 108 actuates the seventh and eighth switches S7, S8 to connect the battery 24 to the impedance sensor 106, closing the first current loop 202. The controller module 108 then determines the resonant frequency of the alternating current based on data collected by the impedance sensor 106, which determines the first constant $k_1$.

The controller module 108 then actuates the seventh and eighth switches S7, S8 to disconnect the impedance sensor 106 from the battery 24. The controller module 108 then disconnects the fifth and sixth switches S5, S6 to disconnect the battery 24. The controller module 108 disconnects the first and second switches S1, S2 and actuates the third and fourth switches S3, S4. Then, the controller module 108 actuates the fifth and sixth switches S5, S6 to connect the battery 24 to the fourth, fifth, and sixth capacitors 216, 216, 218. The controller module 108 actuates the seventh and eighth switches S7, S8 to connect the battery 24 to the impedance sensor 106, closing the second current loop 204. The controller module 108 determines the resonant frequency of the alternating current based on data collected by the impedance sensor 106, which determines the second constant $k_2$. With the first and second constants $k_1 k_2$, the controller module 108 then determines the CM impedance $C_{bat}$. The determined impedance may be output to a memory of the controller module 108 for use in determining whether to replace or repair the battery 24.

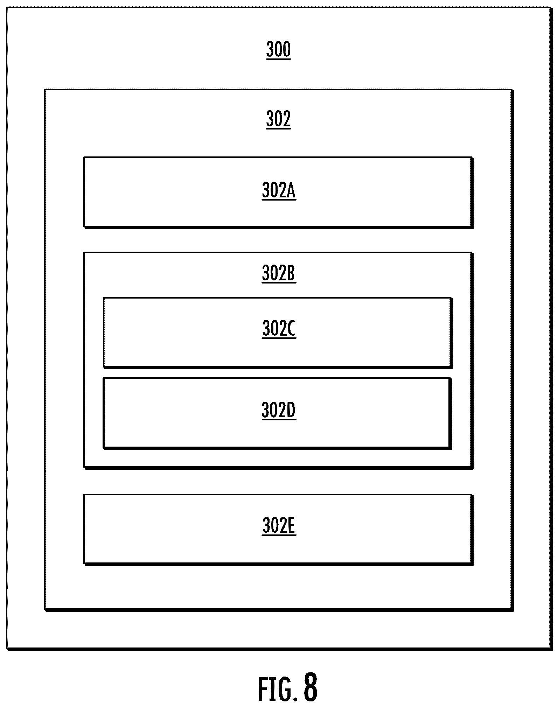

Now referring to FIG. 8, the structure of a controller 300, such as the controller module 108 used to control one or more components of the assemblies of FIGS. 2A-7B, will be described. In at least certain embodiments, the controller 300 can include one or more computing devices 302. The computing devices 302 can include one or more processors 302A and one or more memory devices 302B. The one or more processors 302A can include any suitable processing device, such as a microprocessor, microcontroller, integrated circuit, logic device, or other suitable processing device. The one or more memory devices 302B can include one or more computer-readable media, including, but not limited to, non-transitory computer-readable media, RAM, ROM, hard drives, flash drives, or other memory devices.

The one or more memory devices 302B can store information accessible by the one or more processors 302A, including computer-readable instructions 302C that can be executed by the one or more processors 302A. The instructions 302C can be any set of instructions that when executed by the one or more processors 302A, cause the one or more processors 302A to perform operations. In some embodiments, the instructions 302C can be executed by the one or more processors 302A to cause the one or more processors 302A to perform operations, such as any of the operations and functions for which the controller 300 or the computing devices 302 are configured, the operations for operating power source assemblies as described herein, or any other operations or functions of the one or more computing devices 302. The instructions 302C can be software written in any suitable programming language or can be implemented in hardware. Additionally or alternatively, the instructions 302C can be executed in logically or virtually separate threads on the one or more processors 302A. The one or more memory devices 302B can further store data 302D that can be accessed by the one or more processors 302A. For example, the data 302D can include data indicative of power flows, data indicative of engine/ aircraft operating conditions, or any other data or information described herein.

The computing devices 302 can also include a network interface 302E used to communicate, for example, with the other components of the power source assemblies, the vehicle incorporating the power source assemblies. For example, in the embodiment depicted, as noted above, the power source assemblies include one or more sensors for sensing data indicative of one or more parameters (e.g., power level, current level, voltage). The controller 300 is operably coupled to the one or more sensors through, e.g., the network interface, such that the controller 300 may receive data indicative of various operating parameters sensed by the one or more sensors during operation. In such a manner, the controller 300 may be configured to operate the power source assemblies in response to, e.g., the data sensed by the one or more sensors.

The network interface 302E can include any suitable components for interfacing with one or more networks, including for example, transmitters, receivers, ports, controllers, antennas, or other suitable components.

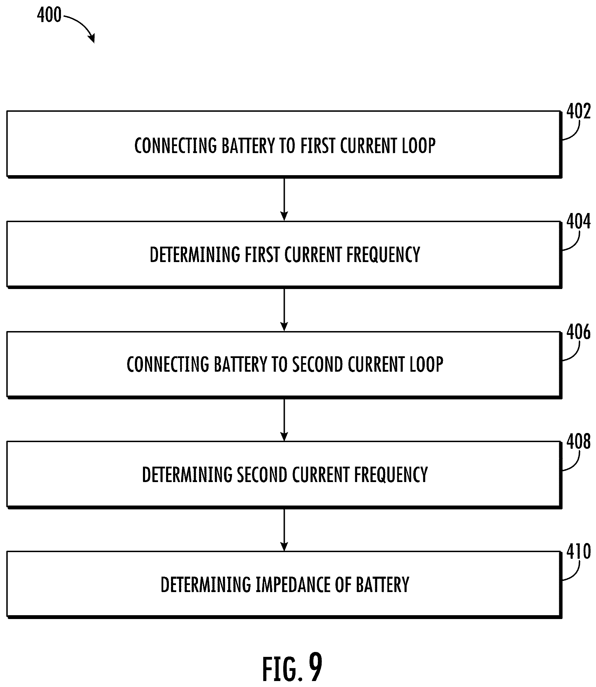

Referring now to FIG. 9, a flow diagram of a method 400 of determining an impedance of a battery in accordance with an exemplary aspect of the present disclosure is provided. The method 400 of FIG. 9 may be utilized to operate one or more of the exemplary assemblies described above with reference to FIGS. 2A-7B.

As is depicted, the method 400 includes at (402) connecting a battery to a first current loop. As described above, the first current loop includes capacitors that block voltage from the battery from reaching an impedance sensor, allowing for use of an impedance sensor that is rated lower than the voltage output of the battery. For example, a first switch may be actuated to connect the battery to the first current loop. The battery may be a battery installed in a hybrid-electric engine of an aircraft, as described above.

The method 400 includes at (404) determining a first current frequency. The impedance sensor can collect data about alternating current in the first current loop, and a controller can determine a resonant frequency of the current based on the collected data. Because the current is in the first current loop, the determined resonant frequency is a "first" current frequency.

The method 400 includes at (406) connecting the battery to a second current loop. The second current loop includes capacitors having different capacitances to the capacitors of the first current loop. For example, a second switch may be actuated to connect the battery to the second current loop.

The method 400 includes at (408) determining a second current frequency of the second current loop. The impedance sensor can collect data about alternating current in the second current loop, and a controller can determine a resonant frequency of the current based on the collected data. Because the current is in the second current loop, the determined resonant frequency is a "second" current frequency.

The method 400 includes at (410) determining the impedance of the battery based on the first and second current frequencies. As described above, the controller determines the CM impedance of the battery based on the determined current frequencies and stored values for the capacitances of the capacitors of the assembly. For example, the controller can determine the impedance using one of Expressions 3 or 7 stated above. The determined impedance may be output to a memory of the controller for use in determining whether to replace or repair the battery.

By using passive capacitive networks to balance voltages between the battery and measurement instruments, the health status of a battery or battery stack for a hybrid-electric engine of an aircraft can be determined. In particular, forming symmetric structures balances the phase-to-neutral and phase-to-ground voltages, allowing for low voltage instruments to be used. The determination of battery health is important for hybrid-electric vehicles to determine whether to perform maintenance or replace the batteries, and the assemblies described above improve operation of aircraft that use hybrid-electric engines.

Further aspects are provided by the subject matter of the following clauses:

An assembly for measuring impedance of a battery includes a first current loop including a first capacitor and a second capacitor in series with the first capacitor, a second current loop in parallel with the first current loop, the second current loop including a third capacitor, an impedance sensor in electrical communication with the first and second current loops, and a controller module configured to determine an impedance of the battery based on data from the impedance sensor indicating a first current frequency from the first current loop and a second current frequency from the second current loop.

The assembly of any of the preceding clauses, wherein the first, second, and third capacitors are configured to maintain a voltage balance between the impedance sensor and the battery.

The assembly of any of the preceding clauses, further including a first terminal, a second terminal, and a third terminal, wherein the first and second terminals are arranged to connect the battery to the first current loop and the first and third terminals are arranged to connect the battery the second current loop.

The assembly of any of the preceding clauses, wherein the controller module is further configured to determine a differential mode impedance when the battery is connected to the first and second terminals and to determine a common mode impedance when the battery is connected to the first and third terminals.

The assembly of any of the preceding clauses, further including a first switch between the first terminal and the first capacitor, a second switch between the second terminal and the second capacitor, and a third switch between the third terminal and the third capacitor.

The assembly of any of the preceding clauses, wherein the first current loop further includes a resistor in parallel with the first and second capacitors and in parallel with the impedance sensor.

The assembly of any of the preceding clauses, wherein the second current loop further includes a second resistor in parallel with the first and third capacitors and in parallel with the impedance sensor.

The assembly of any of the preceding clauses, further including a first switch actuatable to connect the battery to the first current loop and a second switch actuatable to connect the battery to the second current loop.

The assembly of any of the preceding clauses, wherein the second current loop further includes a fourth capacitor in series with the third capacitor.

The assembly of any of the preceding clauses, wherein the controller module is configured to determine an inductance of the battery based on the first current frequency.

The assembly of any of the preceding clauses, wherein the controller module is configured to determine a capacitance of the battery based on the second current frequency.

The assembly of any of the preceding clauses, wherein the controller module is further configured to determine an inductance of the first current loop based on data indicating a current frequency of the first current loop without the battery.

A method for measuring an impedance of a battery connected to a first current loop defined by at least a first capacitor and a second capacitor, the first current loop being in electrical communication with an impedance sensor, the method including determining a first current frequency from the first current loop based on first data collected by the impedance sensor, connecting the battery to a second current loop defined by at least a third capacitor, the second current loop being in electrical communication with the impedance sensor, determining a second current frequency from the second current loop based on second data collected by the impedance sensor, and determining the impedance of the battery based on the first current frequency and the second current frequency.

The method of any of the preceding clauses, further including determining a differential mode impedance based on the first current frequency.

The method of any of the preceding clauses, further including determining a common mode impedance based on the second current frequency and the differential mode impedance.

The method of any of the preceding clauses, wherein determining the impedance of the battery further includes determining an inductance of the battery and a capacitance of the battery.

The method of any of the preceding clauses, wherein determining the impedance of the batter further includes determining a common mode impedance of the battery based the first current frequency and the second current frequency and determining an inductance of the battery based on the common mode impedance.

The method of any of the preceding clauses, further including maintaining a voltage balance between the battery and the impedance sensor while collecting data with the impedance sensor.

The method of any of the preceding clauses, wherein the second current loop is further defined by a fourth capacitor.

The method of any of the preceding clauses, further including actuating a switch to electrically connect the second capacitor to the impedance sensor.

The method of any of the preceding clauses, further comprising outputting the determined impedance to a memory of a controller module for determining whether to repair or replace the battery.

A controller configured to execute the method of any of the preceding clauses.

A computer including a processor and a memory, the memory storing instructions executable by the processor to execute the method of any of the preceding clauses.

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

**Claims**

1. An assembly for measuring impedance of a battery, the assembly comprising:

   a first current loop comprising:

   a first capacitor; and
   a second capacitor in series with the first capacitor;

   a second current loop in parallel with the first current loop, the second current loop comprising:
   a third capacitor;
   an impedance sensor in electrical communication with the first and second current loops; and
   a controller module configured to determine an impedance of the battery based on data from the impedance sensor indicating a first current frequency from the first current loop and a second current frequency from the second current loop.

2. The assembly of claim 1, wherein the first, second, and third capacitors are configured to maintain a voltage balance between the impedance sensor and the battery.

3. The assembly of claim 1 or 2, further comprising a first terminal, a second terminal, and a third terminal, wherein the first and second terminals are arranged to connect the battery to the first current loop and the first and third terminals are arranged to connect the battery the second current loop.

4. The assembly of claim 3, wherein the controller module is further configured to:

determine a differential mode impedance when the battery is connected to the first and second terminals; and determine a common mode impedance when the battery is connected to the first and third terminals.

5. The assembly of claim 3 or 4, further comprising a first switch between the first terminal and the first capacitor, a second switch between the second terminal and the second capacitor, and a third switch between the third terminal and the third capacitor.

6. The assembly of any preceding claim, wherein

the first current loop further comprises a first resistor in parallel with the first and second capacitors and in parallel with the impedance sensor; and
the second current loop further comprises a second resistor in parallel with the first and third capacitors and in parallel with the impedance sensor.

7. The assembly of any preceding claim, further comprising a first switch actuatable to connect the battery to the first current loop and a second switch actuatable to connect the battery to the second current loop.

8. The assembly of any preceding claim, wherein the second current loop further comprises a fourth capacitor in series with the third capacitor.

9. The assembly of any preceding claim, wherein the controller module is configured to

determine an inductance of the battery based on the first current frequency; or
determine a capacitance of the battery based on the second current frequency.

10. The assembly of any preceding claim, wherein the controller module is further configured to determine an inductance of the first current loop based on data indicating a current frequency of the first current loop without the battery.

11. A method for measuring an impedance of a battery connected to a first current loop defined by at least a first capacitor and a second capacitor, the first current loop being in electrical communication with an impedance sensor, the method comprising:

determining a first current frequency from the first current loop based on first data collected by the impedance sensor;
connecting the battery to a second current loop defined by at least a third capacitor, the second current loop being in electrical communication with the impedance sensor;
determining a second current frequency from the second current loop based on second data collected by the impedance sensor; and
determining the impedance of the battery based on the first current frequency and the second current frequency.

12. The method of claim 11, further comprising
determining a differential mode impedance based on the first current frequency and determining a common mode impedance based on the second current frequency and the differential mode impedance.

13. The method of claim 11 or 12, wherein determining the impedance of the battery further comprises determining an inductance of the battery and a capacitance of the battery.

14. The method of any of claims 11 to 13, wherein determining the impedance of the batter further comprises determining a common mode impedance of the battery based the first current frequency and the second current frequency and determining an inductance of the battery based on the common mode impedance.

15. The method of any of claims 11 to 14, further comprising maintaining a voltage balance between the battery and the impedance sensor while collecting data with the impedance sensor.

FIG. 1

FIG. 2A

FIG. 2B

EP 4 760 305 A1

FIG. 3A

FIG. 3B

EP 4 760 305 A1

FIG. 4A

FIG. 4B

FIG.5

FIG. 6A

FIG. 6B

FIG. 7A

FIG. 7B

300

302

302A

302B

302C

302D

302E

FIG. 8

400

402

CONNECTING BATTERY TO FIRST CURRENT LOOP

404

DETERMINING FIRST CURRENT FREQUENCY

406

CONNECTING BATTERY TO SECOND CURRENT LOOP

408

DETERMINING SECOND CURRENT FREQUENCY

410

DETERMINING IMPEDANCE OF BATTERY

FIG. 9

# EP 4 760 305 A1

## EUROPEAN SEARCH REPORT

**Application Number**

EP 25 22 0988

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/145322 A1 (TOYOTA CHUO KENKYUSHO KK [JP]) 3 August 2023 (2023-08-03) <br> * paragraph [0020] - paragraph [0021]; figure 1 * <br> * paragraphs [0022], [0024], [0027], [0035]; figure 2 * <br> * paragraph [0058]; figure 7 * <br> ----- | 1-15 | INV. <br> G01R31/389 <br><br> ADD. <br> G01R31/392 |
| A | WO 2023/189724 A1 (TOYOTA CHUO KENKYUSHO KK [JP]) 5 October 2023 (2023-10-05) <br> * paragraph [0042] - paragraph [0044] * <br> * paragraph [0032] - paragraph [0034]; figure 2 * <br> * paragraph [0049]; figure 3 * <br> ----- | 1-15 | |
| X,P <br><br> A,P | WO 2025/220277 A1 (TOYOTA CHUO KENKYUSHO KK [JP]) 23 October 2025 (2025-10-23) <br> * abstract; figure 1 * <br> * paragraphs [0020], [0027] - [0029]; figure 1 * <br> * paragraph [0030] - paragraph [0031]; figure 2 * <br> ----- | 1-8,11, 15 <br><br> 9,10, 12-14 | |
| | | | **TECHNICAL FIELDS SEARCHED (IPC)** <br><br> G01R <br> H01M |

The present search report has been drawn up for all claims

| Place of search | Date of completion of the search | Examiner |
|---|---|---|
| Munich | 30 April 2026 | Jakob, Clemens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 0988

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2026

| Patent document cited in search report | Publication date | Patent family member(s) | Publication date |
|---|---|---|---|
| WO 2023145322 A1 | 03-08-2023 | CN 118511087 A<br>JP 7802553 B2<br>JP 2023110285 A<br>JP 2024152766 A<br>WO 2023145322 A1 | 16-08-2024<br>20-01-2026<br>09-08-2023<br>25-10-2024<br>03-08-2023 |
| WO 2023189724 A1 | 05-10-2023 | CN 118871317 A<br>JP 2023146536 A<br>WO 2023189724 A1 | 29-10-2024<br>12-10-2023<br>05-10-2023 |
| WO 2025220277 A1 | 23-10-2025 | JP 2025163602 A<br>WO 2025220277 A1 | 29-10-2025<br>23-10-2025 |

EPO FORM P0459

For more details about this annex : see Official Journal of the European Patent Office, No. 12/82